# EUROPÄISCHE PATENTANMELDUNG

(11) **EP 2 339 869 A1**
(43) Veröffentlichungstag der Anmeldung: **29.06.2011**
(21) Anmeldenummer: 09014141.7
(22) Anmeldetag: 12.11.2009
(51) Int. Cl.: H04R 17/00, H01L 41/083, H01L 41/113

(54) **Ferroelektret-Zwei- und Mehrschichtverbund und Verfahren zu dessen Herstellung**

(71) Anmelder: Bayer MaterialScience AG, 51368 Leverkusen (DE)
(72) Erfinder: Jenninger, Werner, Dr., 50677 Köln (DE); Wagner, Joachim, Dr., 51061 Köln (DE); Benecke, Carsten, Dr., 79576 Weil am Rhein (DE)

(57) **Zusammenfassung**

Die vorliegende Erfindung betrifft ein Verfahren zur Herstellung von Zwei- oder Mehrschicht-Ferroelektreten (3) mit definierten Hohlräumen (5) umfassend die folgenden Schritte:
A) Einbringen von einer oder mehreren Ausnehmungen (4a) in mindestens eine Oberflächeseite eines Polymerfolienelements (1) mittels Abtrageverfahren,
B) Aufbringen einer ersten Abdeckung (2) auf die in Schritt A) gebildete, Ausnehmungen (4) umfassende Oberflächenseite des Polymerfolienelements (1), und
C) Verbinden des Polymerfolienelements (1) und der Abdeckung (2) zu einem Polymerfolienverbund (3), wobei die Ausnehmungen (4) unter Ausbildung von Hohlräumen (5) verschlossen werden

und einen, insbesondere nach diesem Verfahren hergestellten Ferroelektret-Zwei-oder Mehrschichtverbund (3). Zudem betrifft die Erfindung ein piezoelektrisches Element enthaltend einen erfmdungsgemäßen Ferroelektret-Mehrschichtverbund (3).

## Beschreibung

Die vorliegende Erfindung betrifft Verfahren zur Herstellung von Zwei- und Mehrschicht-Ferroelektreten mit definierten Hohlräumen und nach diesen Verfahren hergestellte Ferroelektret-Mehrschichtverbunde.

Piezoelektrische Materialien sind in der Lage, einen mechanischen Druck linear in ein elektrisches Spannungssignal umzuwandeln. Umgekehrt kann ein an das piezoelektrische Material angelegtes elektrisches Feld in eine Änderung der Wandlergeometrie transformiert werden. Piezoelektrische Materialien werden bereits in einer Vielzahl von Anwendungen als aktive Komponenten integriert. Hierzu gehören beispielsweise strukturierte Drucksensoren für Tastaturen oder Touchpads, Beschleunigungssensoren, Mikrofone, Lautsprecher, Ultraschallwandler für Anwendungen in der Medizintechnik, der Meerestechnik oder zur Materialprüfung. In der WO 2006/053528 A1 ist beispielsweise ein elektroakustischer Wandler auf Basis eines piezoelektrischen Elements aus Polymerfolien beschrieben.

In den letzten Jahren steht zunehmend eine neue Klasse piezoelektrischer Polymere, die so genannten Ferroelektrete, im Interesse der Forschung. Die Ferroelektrete werden auch Piezoelektrete genannt. Ferroelektrete bestehen aus Polymermaterialien mit einer Hohlraumstruktur, die elektrische Ladungen über lange Zeiträume speichern können. Bisher bekannte Ferroelektrete weisen beispielsweise eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

In der US 4,654,546 ist ein Verfahren zur Herstellung von Polypropylen-Schaumfolien als Vorstufe zu einer Ferroelektretfolie beschrieben. Hierbei werden die Polymerfolien mit Füllstoffpartikeln versetzt. Als Füllstoff wird zum Beispiel Titandioxid eingesetzt. Die Polypropylenfolien werden nach dem Extrudieren biaxial gereckt, so dass sich rund um die Füllstoffpartikel kleine Hohlräume in der Folie ausbilden. Dieses Verfahren wurde inzwischen auch auf andere Polymere angewendet. So wurde zum Beispiel in Eetta Saarimäki, Mika Paajanen, Ann-Mari Savijärvi, and Hannu Minkkinen, Michael Wegener, Olena Voronina, Robert Schulze, Werner Wirges and Reimund Gerhard-Multhaupt "Novel Heat Durable Electromechanical Film: Processing for Electromechanical and Electret Applications", IEEE Transactions on Dielectrics and Electrical Insulation 13, 963-972 (October 2006), die Herstellung von Ferroelektretfolien aus Cyclo-Olefm-Copolymeren (COC) und Cyclo-Olefm-Polymeren (COP) beschrieben. Die geschäumten Polymerfolien haben den Nachteil, dass sich eine breite Verteilung der Bläschengröße ergeben kann. Dadurch können bei dem anschließenden Aufladungsschritt nicht alle Blasen gleichmäßig gut aufgeladen werden.

In mehreren Veröffentlichungen aus den letzten Jahren wurden Mehrschichtsysteme aus geschlossenen äußeren Schichten und einer porösen oder perforierten Mittelschicht beschrieben. Hierzu gehören die Artikel von Z. Hu and H. von Seggern, "Air-breakdown charging mechanism of fibrous polytetrafluoroethylene films", Journal of Applied Physics, Vol. 98, paper 014108, 2005 und "Breakdown-induced polarization buildup in porous fluoropolymer sandwiches: A thermally stable piezoelectret", Journal of Applied Physics, Vol. 99, paper 024102, 2006, sowie die Veröffentlichung von H.C. Basso, R.A.P. Altafilm, R.A.C. Altafilm, A. Mellinger, Peng Fang, W. Wirges, and R. Gerhard "Three-layer ferroelectrets from perforated Teflon-PTFE films fused between two homogeneous Teflon -FEP films" IEEE, 2007 Annual Report Conference on Electrical Insulation and Dielectric Phenomena, 1-4244-1482-2/07, 453-456 (2007) und der Artikel von Jinfeng Huang, Xiaoqing Zhang, Zhongfu Xia, and Xuewen Wang "Piezoelectrets from laminated sandwiches of porous polytetrafluoroethylene films and nonporous fluoroethylenepropylene films" Journal of Applied Physics, Vol. 103, paper 084111, 2008. Die Schichtsysteme mit einer porösen oder perforierten Mittelschicht haben gegenüber den vorstehend beschriebenen Systemen häufig größere Piezokonstanten.

In den Veröffentlichungen von X. Zhang, J. Hillenbrand und G. M. Sessler, "Thermally stable fluorocarbon ferroelectrets with high piezoelectric coefficient". Applied Physics A, Vol. 84, pp. 139-142, 2006 und "Ferroelectrets with improved thermal stability made from fused fluorocarbon layers", Journal of Applied Physics, Vol. 101, paper 054114, 2007, sowie in Xiaoqing Zhang, Jinfeng Huang and Zhongfu Xia "Piezoelectric activity and thermal stability of cellular fluorocarbon films" PHYSICA SCRIPTA Vol. T129 pp 274-277, 2007 ist eine Strukturierung der Polymerschichten durch Aufdrücken eines Metallgitters auf einen Polymerschichtstapel aus mindestens drei in alternierender Reihenfolge übereinander gelagerten FEP- und PTFE-Schichten beschrieben. Durch das Zusammenpressen der Schichten durch das Gitter bei einer Temperatur, die über dem Schmelzpunkt von FEP und unter dem von PTFE liegt, werden die Polymerschichten entsprechend der Gitterstruktur derart miteinander verbunden, dass sich zwischen den Gitterstäben kuppelförmige oder blasenförmige Hohlräume mit rechteckiger Grundfläche bilden. Dieses Verfahren führt jedoch zu Ferroelektreten mit unterschiedlicher Qualität, da die Bildung gleichförmiger Hohlräume vor allem bei zunehmender Schichtenanzahl nur schwer kontrolliert werden kann.

Ein anderes Verfahren zur Herstellung blasenförmiger Hohlräume unter Verwendung eines Gitters ist durch R. A. C. Altafim, H. C. Basso, R. A. P. Altafim, L. Lima, C. V. De Aquino, L. Gonalves Neto and R. Gerhard-Multhaupt, in "Piezoelectrets from thermo-formed bubble structures of fluoropolymer-electret films", IEEE Transactions on Dielectrics and Electrical Insulation, Vol. 13, No.5, pp. 979-985, 2006 beschrieben worden. Hierbei werden zwei übereinander angeordnete Teflon-FEP-Folien zwischen einem Metallgitter und einem oberen zylinderförmigen Metallteil angeordnet. Dieser Aufbau wird mit dem Metallgitter auf ein unteres zylinderförmiges Metallteil aufgepresst, welches Öffnungen zur Anlegung eines Vakuums aufweist. Die FEP-Folien werden durch das obere Metallteil erhitzt und durch ein an das untere Metallteil angelegtes Vakuum wird die untere Folie in die Öffnungen des Gitters gezogen und entsprechende Hohlräume gebildet. Die beschriebenen Verfahren unter Verwendung eines Gitters zur Ausbildung von Hohlräumen in den Polymer-Mehrschichtverbunden sind aufwendig und schwierig in den großtechnischen Maßstab zu übertragen.

Eine vorteilhaft einfache Herstellungsmethode für Ferroelektrete mit röhrenförmigen Hohlräumen homogener Größe und Struktur wurde von R. A. P. Altafim, X. Qiu, W. Wirges, R. Gerhard, R. A. C. Altafim, H.C. Basso, W. Jenninger und J. Wagner in dem Artikel "Template-based fluoroethylenepropylene piezoelectrets with tubular channels for transducer applications", Journal of Applied Physics, 106, 014106, 2009 beschrieben. Bei dem dort beschriebenen Verfahren wird zunächst eine Sandwichanordnung zweier FEP-Folien und einer dazwischen eingelegten PTFE-Maskenfolie bereitgestellt. Der gebildete Folienstapel wird laminiert, die FEP-Folien miteinander verbunden und nachfolgend die Maskenfolie unter Freigabe der Hohlräume entfernt.

Ferroelektrete sind für kommerzielle Anwendungen, beispielsweise für Sensor-, Aktor- und Generatorsysteme, weiterhin von zunehmendem Interesse. Für die Wirtschaftlichkeit ist dabei eine Anwendbarkeit eines Herstellungsverfahrens im industriellen Maßstab essentiell.

Der Erfindung liegt daher die Aufgabe zu Grunde alternative Verfahren zur Herstellung von Ferroelektret-Mehrschichtverbunden bereitzustellen, mit denen definierte Ferroelektret-Hohlraumstrukturen erzeugt werden können und die einfach und kostengünstig auch im großtechnischen und industriellen Maßstab durchführbar sind.

Diese Aufgabe wird erfindungsgemäß durch das Verfahren zur Herstellung von Ferroelektret-Mehrschichtverbunden gemäß Anspruch 1 und einem nach diesem Verfahren hergestellten Ferroelektret-Mehrschichtverbund gemäß Anspruch 12 gelöst.

Erfindungsgemäß wird ein Verfahren zur Herstellung eines Ferroelektret- Zwei- oder Mehrschichtverbunds mit definierten Hohlräumen vorgeschlagen, das die folgenden Schritte umfasst:
A) Einbringen von einer oder mehreren Ausnehmungen in mindestens eine Oberflächeseite eines Polymerfolienelements mittels Abtrageverfahren,
B) Aufbringen einer ersten Abdeckung auf die in Schritt A) gebildete, Ausnehmungen umfassende Oberflächenseite des Polymerfolienelements, und
C) Verbinden des Polymerfolienelements und der ersten Abdeckung, zu einem Polymerfolienverbund wobei die Ausnehmungen unter Ausbildung von Hohlräumen verschlossen werden.

Unter einer Abdeckung wird erfindungsgemäß eine Polymerfolie oder ein Polymerfolienverbund verstanden, mit der die Ausnehmung oder die Ausnehmungen der ersten Oberfläche der ersten Polymerfolie unter Ausbildung von Hohlräumen verschlossen werden können und gleichzeitig auf der anderen Oberflächenseite im entstehenden Polymerschichtverbund eine nach außen gerichtete durchgehende Oberfläche ohne Ausnehmungen ausbildet.

Die erfindungsgemäß hergestellten Ferroelektret-Zwei- und Mehrschichtverbunde können mit anderen Worten stapelförmig geschichtete Polymerfolien und mindestens zwischen zwei Polymerfolien ausgebildete Hohlräume aufweisen. Die zueinander gerichteten Oberflächen des Polymerfolienelements, und der Abdeckung, sind dabei zwischen den Hohlräumen miteinander verbunden. Vorteilhafterweise können die Form und Dimensionierung der Hohlräume erfindungsgemäß sehr genau vorbestimmt und definiert hergestellt werden. Die Abtragung von Polymermaterial in Schritt A) und damit die Ausbildung von Ausnehmungen in mindestens einer Oberfläche mindestens des Polymerfolienelements ist im erfindungsgemäßen Verfahren dabei maßgeblich für die Ausbildung der definierten Hohlräume im entstehenden Polymerfolienverbund.

Vorteilhafterweise können die Ausnehmungen durch das erfindungsgemäße Verfahren in zahlreichen unterschiedlichen Formen ausgebildet werden. Die Form der Ausnehmungen ist nicht auf eine zylindrische Form mit einer kreisförmigen Querschnittsfläche beschränkt. Darüber hinaus bietet das erfindungsgemäße Verfahren die Möglichkeit, in unterschiedlichen Formen ausgebildete Ausnehmungen zu kombinieren. Auf diese Weise kann zum einen vorteilhafterweise das Gesamthohlraumvolumen der resultierenden Hohlräume maximiert werden. Zum anderen können die elektromechanischen, insbesondere piezoelektrischen, Eigenschaften der mit dem erfindungsgemäßen Verfahren hergestellten Ferroelektret- Zwei oder Mehrschichtverbunde und elektromechanischen Wandler, durch Auswahl der Ausnehmungsform, deren Anordnung und/oder Verteilung angepasst werden.

Im einfachsten Fall kann die Abdeckung erfindungsgemäß eine durchgehende Polymerfolie vollständig ohne Ausnehmungen und das Polymerfolienelement eine Polymerfolie sein. Wird die Abdeckung dann auf die erste Ausnehmungen umfassende Oberflächenseite der Polymerfolie aufgebracht, kann ein erfindungsgemäßer Ferroelektret-Zweischichtverbund mit Hohlräumen entstehen.

Grundsätzlich können die eingesetzten Polymerfolien des Polymerfolienelements und die Abdeckung aus jedem Kunststoff gefertigt sein, der die Einbringung von Ausnehmungen durch Abtrageverfahren, die Verbindung zwischen den Polymerfolien und eine Ausbildung von Hohlräumen erlaubt und weiterhin dazu geeignet ist einen Polungsprozess in den Hohlräumen zu ermöglichen und die nach dem Aufladungsprozess in den Polymerfilmen gebildeten Ladungsschichten zu separieren.

Die für den erfmdungsgemäßen Ferroelektret Zwei- oder Mehrschichtverbund eingesetzten Polymerfolien können erfindungsgemäß aus gleichen oder unterschiedlichen Polymermaterialien, beispielsweise aus der Gruppe der Polycarbonate, perfluorierten oder teilfluorierten Polymere und - Copolymere wie PTFE, Fluorethylenpropylen (FEP), Perfluoralkoxyethylenen (PFA), Polyestern wie Polyethylenterephthalat (PET) oder Polyethylennaphthalat (PEN), Cyclo-Olefm-Polymere, Cyclo-Olefm-Copolymere, Polyimiden, insbesondere Polyetherimid, Polyethern, Polymethylmethacrylat und Polypropylen oder Polymerblends ausgewählt sein. Mit diesen Materialien können gute bis sehr gute Piezoaktivitäten erzielt werden. Die erfindungsgemäß breite Materialauswahl kann vorteilhafterweise auch eine Anpassung auf bestimmte Anwendungen ermöglichen.

Die Polymerfolien können jeweils bevorzugt eine Dicke von ≥10 µm bis ≤500 µm, besonders bevorzugt von ≥15 µm bis ≤300 µm aufweisen. Die Dicke der unterschiedlichen Polymerfolien, mit anderen Worten deren Schichtdicke, in einem erfindungsgemäßen Ferroelektret-Mehrschichtverbund kann dabei gleich oder unterschiedlich gewählt werden. Eine besonders geeignete Dicke der Polymerfolien kann dabei vorteilhafterweise jeweils in Abhängigkeit des Polymermaterials und im Hinblick auf die angestrebte Anwendung ausgewählt werden. Es kommt grundsätzlich darauf an, dass die in Schritt C) des Verfahrens ausgebildeten Hohlräume nicht kollabieren. So können steifere Materialien dünner ausgeführt werden als vergleichsweise elastischere Polymermaterialien.

Die Polymerfolien können als Folienblätter oder insbesondere im Hinblick auf eine großtechnische Herstellung vorteilhafterweise auch als Folienbahnen ausgestaltet sein, die in Schritt B) übereinander angeordnet und unter Ausbildung der Hohlräume in Schritt C) miteinander verbunden werden können. Die Folienblätter können dabei beispielsweise eine rechteckige, eine regelmäßige oder unregelmäßige Vieleckform oder eine runde, beispielsweise kreisförmige, elliptische oder ovale Grundfläche aufweisen, wobei die übereinander angeordneten Folien zweckmäßigerweise, zumindest im übereinander angeordneten Bereich, die gleiche Grundfläche aufweisen. Grundsätzlich kann die Grundfläche auch an eine spezielle Anwendung angepasst werden.

In einem erfindungsgemäßen Schritt D) kann für die elektrische Aufladung und Polung der inneren Oberflächen der Hohlräume mit entgegengesetzten elektrischen Ladungen vorteilhafterweise auf bekannte und etablierte Methoden zurückgegriffen werden. Eine Polung der sich gegenüberliegenden Seiten der Hohlräume kann beispielsweise durch eine Corona-Entladung oder durch Plasmaverfahren realisiert werden. Eine Corona-Behandlung ist vorteilhafterweise auch großtechnisch gut einsetzbar.

Durch die in Schritt A) durchgeführte Abtragung und Ausbildung von Ausnehmungen in einer Polymerfolie und die Verbindung mit mindestens einer Abdeckung in Schritt B) können mit dem bereitgestellten Verfahren genau vorbestimmte Hohlräume erzeugt und defmiert hergestellt werden. Ein weiterer Vorteil ist daher, dass mit der erfmdungsgemäßen Vorgehensweise unterschiedliche Resonanzfrequenzen, wie sie bei geschäumten Ferroelektret-Folien unkontrolliert durch ungleichförmige Blasen auftreten, vermieden werden können. Im Gegensatz dazu ist es erfindungsgemäß sogar möglich, auch in Teilbereichen des entstehenden Polymerfolienverbunds unterschiedlich ausgestaltete Hohlräume zu erzeugen und damit unterschiedliche Eigenschaften, beispielsweise Piezoaktivitäten, einzustellen.

In einer Ausführungsform des Verfahrens können die Abtragung und damit die Einbringung von Ausnehmungen in die mindestens eine Oberfläche der ersten Polymerfolie in Schritt A) durch Laserablation oder Ätzen erfolgen. Gleichermaßen bevorzugt können Abtrageverfahren wie Hobeln, Fräsen oder Schleifen zur Ausbildung der Ausnehmungen eingesetzt werden. Sowohl Form als auch Dimensionierung der dann im nächsten Schritt B) durch Aufbringung der Abdeckung ausgebildeten Hohlräume ist mit den vorstehend genannten Methoden zur Ausbildung der Ausnehmungen vorteilhafterweise nahezu frei wählbar und kann in Abhängigkeit mit den Folienmaterialen und deren Eigenschaften und der jeweiligen Foliendicke auf die gewünschten mechanischen und elektrischen Anforderungen der jeweiligen Anwendung angepasst werden. Die Erfindung umfasst ebenfalls, dass die gleichen Ausnehmungen gegebenenfalls mittels verschiedener Abtrageverfahren in eine Polymerfolie eingebracht werden können.

In einer Ausführungsform des Verfahrens kann in eine Oberflächenseite der Abdeckung in einem Schritt A1) ebenfalls eine oder mehrere Ausnehmungen eingebracht werden. Die Einbringung der Ausnehmungen kann dabei beispielsweise gleichermaßen durch Laserablation, Ätzen Hobeln, Fräsen und/oder Schleifen erfolgen. Die Aufbringung der Abdeckung auf die erste Oberflächenseite mit Ausnehmungen des Polymerfolienelements kann erfindungsgemäß beispielsweise derart erfolgen, dass die Ausnehmungen in den zueinander gerichteten Oberflächenseiten von Polymerelement und Abdeckung ganz oder teilweise überlappen, so dass die Ausnehmungen mindestens einen gemeinsamen Hohlraum bilden können. Zum Beispiel können die Oberflächenseiten mit den Ausnehmungen von Polymerelement und Abdeckung dabei deckungsgleich ausgestaltet sein. Die Ausnehmungen in den Oberflächenseiten von Polymerelement und Abdeckung können aber auch gerade nicht überlappend angeordnet sein, so dass in diesem Fall durch die Verbindung von Polymerfolienelement und Abdeckung zwei Lagen von Hohlräumen entstehen können. Die Hohlräume der beiden Lagen sind in diesem Fall versetzt zueinander angeordnet.

Die eingesetzten Polymerfolien in Polymerfolienelement und der Abdeckung können beispielsweise eine Dicke von ≥10 µm bis ≤800 µm und die gebildeten Ausnehmungen eine Tiefe von ≥10 µm bis ≤500 µm, sowie eine Breite von ≥10 µm bis ≤5000 µm aufweisen. Bevorzugt ist für die Hohlräume eine Höhe von ≥10µm ≤250 µm und eine Breite von ≥50µm bis ≤3000 µm. Besonders bevorzugt haben die Hohlräume eine Breite von ≥100 µm bis ≤2000 µm. Die Kombination der Folieneigenschaften und der Form und Dimensionierung der ausgebildeten Hohlräume wird dabei so gewählt, dass die auf Abstand zu haltenden Folienabschnitte sich in keinem Nutzungsfall berühren können. Die genannten Abtrageverfahren haben weiterhin den Vorteil, dass sie automatisierbar sind und gegebenenfalls als kontinuierlicher Prozess durchgeführt werden können.

In einem erfmdungsgemäß hergestellten Ferroelektret-Mehrschichtverbund können die Hohlräume bei einer Polymerfoliendicke von ≥10 µm bis ≤500 µm beispielsweise eine Höhe von ≥10 µm bis ≤500 µm aufweisen. Mit der Höhe ist insbesondere die Höhe der Hohlräume im Querschnitt gemeint. Besonders bevorzugt können die Hohlräume eine Höhe von ≥10 µm bis ≤250 µm aufweisen.

Die Hohlräume können durch das erfmdungsgemäße Verfahren in zahlreichen unterschiedlichen Formen ausgebildet werden. Die Form der Hohlräume ist daher nicht auf eine blasenförmige, zylindrische, röhrenförmige oder kanalartige Form mit einer kreisförmigen oder rechteckigen Querschnittsfläche senkrecht zum Schichtverlauf der Polymerfolien beschränkt. Darüber hinaus bietet das erfindungsgemäße Verfahren die Möglichkeit, in unterschiedlichen Formen ausgebildete Hohlräume zu kombinieren. Auf diese Weise kann zum einen vorteilhafterweise das Gesamthohlraumvolumen der resultierenden Hohlräume maximiert werden. Zum anderen können die elektromechanischen, insbesondere piezoelektrischen, Eigenschaften der mit dem erfindungsgemäßen Verfahren hergestellten Ferroelektret-Mehrschichtverbunde und elektromechanischen Wandler durch Auswahl der Hohlraumform, -größe, und -gestalt, ihrer Anzahl, Anordnung und/oder Verteilung angepasst werden.

Die Hohlräume können in Formen mit einer eher geringen Flächeausdehnung, wie Linien, beispielsweise gebogene oder gerade, einzelne oder gekreuzte Linien beziehungsweise Umfangslinien von geometrischen Figuren, etwa einer Kreislinie oder einer Umfangslinie eines Kreuzes, oder als Strukturen mit einer größeren Fläche, wie Rechtecke, Kreise, Kreuze, et cetera, ausgebildet werden. Die Form und Dimensionierung der Hohlräume wird vorzugsweise derart eingestellt, dass sich die Polymerfolien, senkrecht zu deren Schichtverlauf innerhalb des Hohlraums nicht berühren können und/oder das das nach Fertigstellung resultierende Gesamthohlraumvolumen möglichst groß ist. Mit anderen Worten sollen sich insbesondere die durch Polung auf die inneren Oberflächen der Hohlräume aufgebrachten positiven und negativen Ladungen nicht berühren können.

Die Hohlräume können in Formen ausgebildet sein, welche eine Querschnittsfläche parallel zum Schichtverlauf der Polymerfolien ausgewählt aus der Gruppe von im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen. Die Hohlräume in verschiedenen Lagen zwischen den verschiedenen Polymerfolien im Folienstapel können dabei gleich oder unterschiedlich ausgestaltet sein. Dies umfasst sowohl deren Form, Größe und Gestalt als auch die Anzahl der Hohlräume, ihre Anordnung und/oder Verteilung.

Die Hohlräume innerhalb des gebildeten Polymerfolienverbunds können den herzustellenden Ferroelektret-Mehrschichtverbund vorteilhafterweise entlang seiner Dicke weicher machen, damit dessen Elastizitätsmodul erniedrigen, und einen Polungsprozess in den resultierenden Hohlräumen ermöglichen.

Im Rahmen des erfmdungsgemäßen Verfahrens können die Hohlräume im gebildeten Polymerfolienverbund sowohl homogen als auch heterogen verteilt ausgebildet sein. Insbesondere kann es in Abhängigkeit vom Anwendungsbereich des herzustellenden Ferroelektret-Mehrschichtverbunds auch vorteilhaft sein, die Hohlräume gezielt, ortsaufgelöst heterogen verteilt auszubilden.

In einer Ausfiihrungsform des erfindungsgemäßen Verfahrens ist vorgesehen, das Polymerfolienelement und/oder die Abdeckung mindestens eine erste und eine zweite miteinander verbundene Polymerfolie umfassen, wobei insbesondere in Schritt A) die Einbringung der Ausnehmungen in die Oberflächenseite des Polymerfolienelements und/oder in Schritt A1) die Einbringung der Ausnehmungen in die Oberflächenseite der Abdeckung durchgängig bis zur zweiten Polymerfolie erfolgen kann. Mit anderen Worten können die Ausnehmungen durch Abtragung des Polymermaterials durchgängig bis zur Grenzfläche zur nächsten verbundenen Polymerfolie eingebracht werden. Vorteilhafterweise können hierdurch die Hohlraumhöhen noch genauer eingestellt werden und somit auf einfache Weise besonders gleichmäßige Hohlräume erzeugt werden.

Das Verbinden der Polymerfolien zu einem Polymerfolienverbund in Schritt C) kann erfindungsgemäß beispielsweise durch Laminieren, Kleben, Klammern, Klemmen, Schrauben, Nieten oder Schweißen, insbesondere durch Laserschweißen, Ultraschallschweißen oder Vibrationsschweißen erfolgen.

Die Verbindung der Polymerfolien durch Laminieren kann insbesondere thermisch, unter erhöhtem Druck und/oder mittels Ultraschall und/oder mittels Bestrahlung mit Ultraviolettem Licht oder Infrarot-Licht durchgeführt werden. Hierdurch kann vorteilhafterweise die Materialauswahl für die Polymerfolien noch vergrößert werden. Die Bedingungen für die Laminierung werden dabei zweckmäßigerweise so gewählt, dass die Folienschichten sich verbinden, die Strukturierung des Polymerfolienelements durch die Ausnehmungen dabei jedoch weitestgehend erhalten bleiben und so eine Formbeständigkeit und definierte Ausbildung der Hohlräume sichergestellt wird. Vor dem Laminieren kann das Material des strukturierten Polymerfolienelements und/oder das Material der Abdeckung vollständig verfestigt, beispielsweise vollständig getrocknet und/oder vollständig vernetzt, und/oder vollständig erstarrt und/oder vollständig kristallisiert werden. Hierdurch kann die Formbeständigkeit des verfahrensgemäß entstehenden, Hohlräume umfassenden Polymerfolienverbunds verbessert werden.

In einer weiteren Ausgestaltung können die Polymerfolien auch zusätzlich zur Laminierung durch eine Verklebung miteinander verbunden werden. Diese Verklebung kann beispielsweise mittels Acrylatkleber hergestellt werden. Hierdurch kann die mechanische Verbindung der Polymerfolien unterstützt und verbessert werden.

Die Verbindung der Polymerfolien in Schritt C) mittels einer Klebung kann beispielsweise mit Acrylatkleber erfolgen. Alternativ ist es auch möglich, insbesondere bei der Verbindung von Polymerfolien aus gleichem Material, die Verbindung durch Aufbringen eines guten Lösungsmittels oder einer Lösungsmittelzusammensetzung für das jeweilige Polymermaterial auf eine oder beide Folien, nachfolgendes Zusammendrücken der Folien und Verdunsten des Lösungsmittels zu erzielen. Es ist zum Beispiel möglich Polycarbonatfolien mit Methylenchlorid zu verkleben. Vorteil bei der Verbindung durch Lösungsmittel ist, dass keine thermische Belastung auftritt und gerade bei thermisch verformbaren Polymermaterialien die Formbeständigkeit verbessert und ein Kollabieren der ausgebildeten Hohlräume vermieden werden kann.

In einer anderen Ausgestaltung des Verfahrens kann vor und/oder nach der elektrischen Aufladung der inneren Oberflächen der Hohlräume in Schritt D) die Aufbringung von Elektroden an den äußeren Oberflächen des Polymerfolienverbunds erfolgen. Zu diesem Zweck können im erfindungsgemäß entstehenden Ferroelektret Zwei- oder Mehrschichtverbund die beiden nach außen gerichteten Polymerfolien-Oberflächen durchgehende Oberflächen ohne Ausnehmungen sein. Unter der Aufbringung von Elektroden an den äußeren Oberflächen wird die Bereitstellung einer leitenden Oberflächenbeschichtung in mindestens einem Teilbereich, insbesondere auf den nach außen gerichteten Oberflächen des Polymerverbunds verstanden. Die Elektroden werden bevorzugt auf durchgehenden Oberflächen, dass heißt auf Oberflächen ohne Ausnehmungen, der eingesetzten Polymerfolien angeordnet.

Erfmdungsgemäß kann nach der Aufbringung von Elektroden auf den äußeren Oberflächen des Ferroelektret-Mehrschichtverbunds eine direkte Aufladung durch Anlegung einer elektrischen Spannung erfolgen. Vor der Aufbringung von Elektroden kann eine Polung der sich gegenüberliegenden Seiten der Hohlräume beispielsweise durch eine Corona-Entladung realisiert werden. Eine Corona-Behandlung ist vorteilhafterweise auch großtechnisch gut einsetzbar. Erfindungsgemäß ist es auch möglich, zunächst auf einer Oberfläche eine leitende Oberflächenbeschichtung bereitzustellen, den Polymerverbund dann aufzuladen und abschließend eine zweite Elektrode auf der gegenüberliegenden äußeren Oberfläche aufzubringen.

Mit anderen Worten können die erfindungsgemäß hergestellten Ferroelektret-Mehrschichtverbunde auf den nach außen gerichteten Oberflächen der Polymerfolien mindestens teilweise eine leitende Beschichtung aufweisen. Diese leitenden Bereiche können als Elektroden genutzt werden. Die leitende Beschichtung, das heißt die Elektroden, können dabei flächig und/oder auch strukturiert aufgebracht werden. Eine strukturierte leitende Beschichtung kann beispielsweise als eine Aufbringung in Streifen oder in Gitterform ausgestaltet sein. Hierdurch kann zusätzlich die Empfindlichkeit des Ferroelektret-Mehrschichtverbunds beeinflusst und auf bestimmte Anwendungen angepasst werden.

Bei den ausgewählten Elektrodenmaterialien kann es sich um dem Fachmann bekannte leitfähige Materialien handeln. Erfindungsgemäß kommen hierfür beispielsweise Metalle, Metall-Legierungen, leitfähige Oligo- oder Polymere, wie z.B. Polythiophene, Polyaniline, Polypyrrole, leitfähige Oxide, wie z.B. Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie z.B. Russ, Kohlenstoffnanoröhrchen (Carbonanotubes (CNTs)) oder wiederum leitfähige Oligo- oder Polymere, in Frage. Der Füllstoffgehalt der Polymere liegt dabei oberhalb der Perkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Drucken, Rakeln, Lackschleudern (Spin-Coating), Aufkleben oder Aufdrücken einer leitenden Schicht in vorgefertigter Form oder durch eine Sprühelektrode aus einem leitenden Kunststoff realisiert werden. Die Elektroden können dabei strukturiert, beispielsweise in Streifen oder in Gitterform, ausgestaltet sein. Beispielsweise können erfindungsgemäß die Elektroden auch derart strukturiert sein, dass der Ferroelektret-Mehrschichtverbund als elektromechanischer Wandler aktive und passive Bereiche aufweist. Insbesondere können die Elektroden derart strukturiert sein, dass, insbesondere in einem Sensor-Modus, die Signale ortsaufgelöst detektiert und/oder, insbesondere in einem Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Erfmdungsgemäß umfasst ist auch, dass zwei oder mehr Ferroelektret-Mehrschichtverbunde mit gleich gepolter leitender Schicht, das heißt also Elektrode, verbunden werden können. Mit anderen Worten kann zwischen zwei erfindungsgemäßen Ferroelektret Mehrschichtverbunden eine Zwischenelektrode gebildet werden, die gegen die beiden Elektroden auf den dann äußeren Oberflächen geschaltet werden kann. Hierdurch können die Ferroelektret-Mehrschichtverbunde in Reihe geschaltet und der erzielbare piezoelektrische Effekt verdoppelt, bzw. vervielfacht werden.

Die erfindungsgemäßen Ferroelektret-Mehrschichtverbunde enthalten bevorzugt zwei Elektroden. Bei erfmdungsgemäßen elektromechanischen Wandlern mit mehr als zwei Elektroden kann es sich beispielsweise um Stapelaufbauten aus mehreren, vorzugsweise erfindungsgemäß hergestellten, Ferroeletkret-Mehrschichtverbund-Systemen handeln.

In einer anderen Ausgestaltung des erfindungsgemäßen Verfahrens können die Schritte A), B), C) und/oder D) als kontinuierlicher Rolle-zu-Rolle Prozess durchgeführt werden. Vorteilhafterweise kann die Herstellung der Mehrschichtverbunde also mindestens teilweise als kontinuierlicher Prozess, vorzugsweise als Rolle-zu-Rolle Prozess, durchgeführt werden. Dies ist besonders vorteilhaft für die Anwendung der Verfahren im großtechnischen und industriellen Maßstab. Die Automatisierung zumindest eines Teils der Herstellungsverfahren vereinfacht die Verfahren und ermöglicht die kostengünstige Produktion der Ferroelektret-Mehrschichtverbunde mit Hohlräumen. Erfindungsgemäß sind vorteilhafterweise alle Schritte des Verfahrens einer Automatisierung zugänglich.

In einer anderen Ausgestaltung kann in einem weiteren Schritt E) vor oder nach der Aufladung in Schritt D) das Versiegeln der Kanten des in Schritt C) gebildeten Polymerfolienverbunds umfasst sein. Die erfindungsgemäßen Mehrschichtverbunde können damit vorteilhafterweise an den Rändern versiegelt werden, um diese hermetisch vor Umwelteinflüssen zu schützen, z. B. bei Anwendungen in einer aggressiven Umgebung, beispielsweise bei Atmosphären mit hoher Luftfeuchtigkeit oder unter Wasser.

In einer anderen Ausführungsform des erfindungsgemäßen Verfahrens kann in die ausgebildeten Hohlräume ein Gas eingefüllt werden. Das Gas kann dabei beispielsweise reiner Stickstoff (N₂), Stickstoffoxid (N₂O) oder Schwefelhexafluorid (SF₆) sein. Durch die Gasbefüllung können vorteilhafterweise bei den erfindungsgemäß hergestellten Ferroelektret-Mehrschichtverbunden durch die Polung nochmals deutlich höhere Piezokonstanten erzielt werden.

Ein immenser Vorteil der bereitgestellten erfindungsgemäßen Verfahren auch in ihren verschiedenen vorstehend beschriebenen Ausgestaltungen ist, dass diese in weiten Bereichen materialunabhängig sind und hierdurch eine breite Anwendungsmöglichkeit gegeben ist.

Die Erfmdung betrifft weiterhin einen Ferroelektret- Zwei- oder Mehrschichtverbund, insbesondere einen Ferroelektret- Zwei- oder Mehrschichtverbund hergestellt nach einem Verfahren gemäß der vorstehenden Beschreibung umfassend
- mindestens ein erstes Polymerfolienelement mit mindestens einer Ausnehmungen umfassenden Oberflächenseite, und
- mindestens eine erste Abdeckung ,
wobei die Abdeckung auf der ersten Ausnehmungen umfassenden Oberflächeseite der ersten Polymerfolie angeordnet ist, und
wobei die Ausnehmungen durch die Abdeckung unter Ausbildung von Hohlräumen verschlossen sind.

Hierbei können die verschiedenen bereitgestellten Varianten des Herstellungsverfahrens und den daraus resultierenden Ferroelektret-Mehrschichtverbunden auch gegebenenfalls in Kombination miteinander durchgeführt werden. Solche erfindungsgemäßen Zwei- und Mehrschichtverbunde weisen stapelförmig geschichtete Polymerfolien und mindestens zwischen zwei Polymerfolien ausgebildete Hohlräume auf. Die Polymerfolien sind dabei zwischen den Hohlräumen miteinander verbunden. Vorteilhafterweise können die Form und Dimensionierung der Hohlräume erfindungsgemäß sehr genau vorbestimmt und definiert hergestellt werden.

In einer Ausführungsform der Erfindung können das Polymerfolienelement und/oder die Abdeckung erfindungsgemäß auch mindestens zwei miteinander verbundene Polymerfolien umfassen. Hierdurch kann die Variabilität der erzeugbaren Ferroelektret-Mehrschichtverbunde noch erhöht werden. Über die gewählte Gesamtzahl der Polymerfolien und der gewählten Abfolge Polymerfolien in Polymerfolienelement und Abdeckung mit und ohne Ausnehmungen kann die Gesamthöhe und die Anzahl der Hohlräume, bzw. Anzahl der Lagen mit Hohlräumen festgelegt werden. In einem erfindungsgemäßen Polymerfolienelement können beispielsweise auch zwei, drei oder mehr Polymerfolien gegebenenfalls auch mit zwischen liegenden Hohlräumen übereinander angeordnet und miteinander verbunden sein. Beispielsweise können Polymerfolien mit Ausnehmungen und durchgehende Polymerfolien alternierend im Folienstapel des Polymerfolienelements übereinander angeordnet werden. Die Erfindung betrifft weiterhin ein piezoelektrisches Element enthaltend einen erfindungsgemäßen Ferroelektret-Mehrschichtverbund. Dieses piezoelektrische Element kann besonders bevorzugt ein Sensor-, Aktor oder Generatorelement sein. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden.

Zusätzlich umfasst die Erfmdung weiterhin eine Vorrichtung zur Herstellung von erfindungsgemäßen Ferroelektret-Zwei- oder Mehrschichtverbunden. Mit anderen Worten betrifft die Erfindung weiterhin eine Vorrichtung zur Durchführung des erfindungsgemäßen Verfahrens, wobei die Vorrichtung Mittel zur Abtragung von Polymermaterial zur Einbringung von Ausnehmungen in mindestens eine Oberflächenseite eines Polymerfolienelements und / oder einer Abdeckung umfasst. Diese Mittel können zum Beispiel Einrichtungen wie ein Fräskopf, ein Hobel oder ein Laser sein.

Zusammenfassend werden erfindungsgemäß Verfahren zur Herstellung von Ferroelektret-Mehrschichtverbunden mit Hohlräumen bereitgestellt, die einfach und kostengünstig auch im großtechnischen Maßstab durchgeführt werden können. Die mit den erfindungsgemäßen Verfahren erzeugten Ferroelektret-Zwei- oder Mehrschichtaufbauten können auch mit einer größeren Anzahl von Schichten mit genau definierter Hohlraumstruktur hergestellt werden. Durch die variable Einstellbarkeit der Querschnittgeometrie und der Dimensionierung, der Form und Größe der Hohlräume, der Schichtenabfolge und Lagenanzahl sowie durch die große Materialauswahl für die eingesetzten Polymerfolien können die erfindungsgemäß erzeugten Ferroelektrete besonders gut auf entsprechende Anwendungsgebiete eingestellt werden.

Die nachfolgend beschriebenen Figuren sollen die Erfindung im Detail weiter erläutern, ohne auf die gezeigten und beschriebenen Ausführungsformen beschränkt zu sein.

Es zeigen
Fig. 1 schematisch die Bildung eines erfmdungsgemäßen Ferroelektret-Zwei-Schichtverbunds,
Fig. 2 schematisch die Bildung eines erfindungsgemäßen Zwei-Schichtverbunds mit einer Abdeckung mit Ausnehmungen,
Fig. 3a eine schematische Querschnittdarstellung eines erfindungsgemäßen Polymerfolienelements aus zwei verbundenen Polymerfolien,
Figur 3b eine schematische Querschnittdarstellung eines erfindungsgemäßen Dreischichtverbunds aus dem in Figur 3a gezeigten Polymerfolienelement 1 und einer durchgehenden Abdeckung 2,
Fig. 3c eine schematische Querschnittansicht des in Fig. 3b gezeigten Ferroelektret-Dreischichtverbunds nach dem Aufladungsprozess und nach dem Anbringen von Elektroden 6a und 6b,
Fig. 4 einen schematischen Querschnitt durch einen erfindungsgemäßen elektromechanischen Wandler mit drei aufeinander gestapelten erfmdungsgemäßen Ferroelektret Mehrschicht-Anordnungen, und
Fig. 5a bis 5e in jeweils einer Draufsicht verschiedene erfmdungsgemäß mögliche Formen von Ausnehmungen in einem Polymerfolienelement und/oder einer Abdeckung.

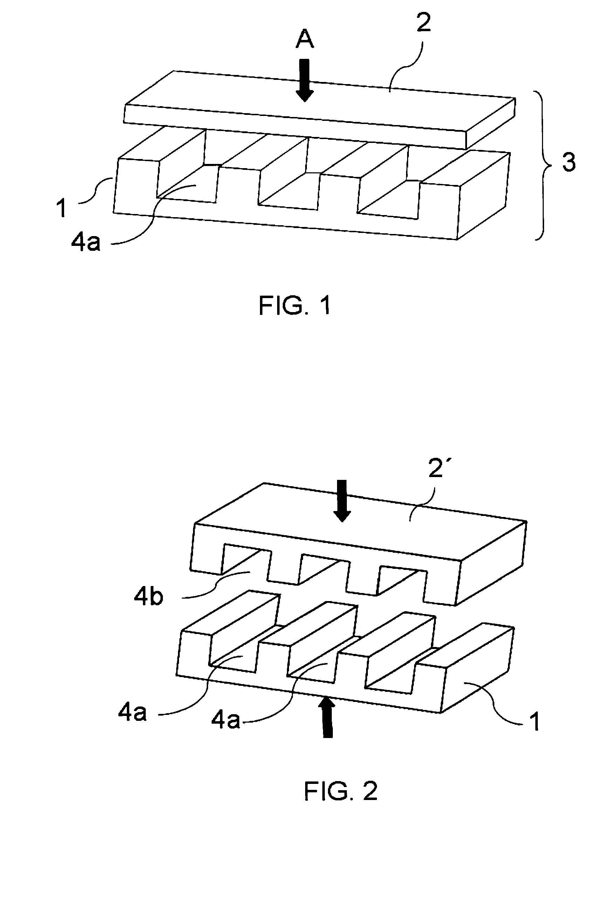

Die Figur 1 zeigt schematisch die erfindungsgemäße Aufbringung einer Abdeckung 2 auf ein Polymerfolienelement 1, also mit anderen Worten den Teilschritt B) in der Herstellung eines erfindungsgemäßen Ferroelektret-Zwei-Schichtverbunds 3. Das Polymerfolienelement 1 ist in der gezeigten Ausführungsform eine Polymerfolie, die in einer Oberflächenseite Ausnehmungen 4a aufweist. Die Abdeckung 2 ist als vollständig durchgehende Polymerfolie ohne Ausnehmungen 4b ausgestaltet und kann auf der Oberflächenseite der Polymerfolie 1 angeordnet werden, in der die Ausnehmungen 4a erfindungsgemäß durch Abtragung von Polymermaterial ausgebildet sind. Das Polymerelement 1 und die Abdeckung 2 können in ihrer Grundfläche gleich ausgestaltet sein und derart übereinander angeordnet werden, dass sie bündig miteinander abschließen. Die Ausnehmungen 4a und daraus mit der Abdeckung 2 gebildeten Hohlräume 5 können in der dargestellten Ausführungsform einen rechteckigen Querschnitt senkrecht und parallel zum Schichtverlauf des Polymerelements 1 und der Abdeckung 2 aufweisen. Die Hohlräume 5 innerhalb des gebildeten Polymerfolienverbunds 3 können den herzustellenden Ferroelektret-Mehrschichtverbund vorteilhafterweise entlang seiner Dicke, also senkrecht zum Schichtverlauf des Polymerfolienelements 1 und der Abdeckung 2 weicher machen, damit dessen Elastizitätsmodul erniedrigen, und einen Polungsprozess in den resultierenden Hohlräumen ermöglichen. Die Verbindung der beiden Polymerfolien 1 und 2 kann erfindungsgemäß beispielsweise durch Laminieren, Kleben, Klammern, Klemmen, Schrauben, Nieten, oder Schweißen erfolgen.

Die Figur 2 zeigt wie Figur 1 den Teilschritt B) des erfindungsgemäßen Verfahrens zur Herstellung eines Ferroelektret-Zwei-Schichtverbunds 3. Das Polymerfolienelement 1 ist in der gezeigten Ausführungsform ebenfalls eine Polymerfolie, die in einer Oberflächenseite Ausnehmungen 4a aufweist. Die Abdeckung 2 ist in der gezeigten erfindungsgemäßen Ausgestaltung auf einer Oberflächenseite ebenfalls mit Ausnehmungen 4b versehen. Die Ausnehmungen 4a und 4b können erfindungsgemäß jeweils mittels Abtrageverfahren wie Laserablation, Ätzen, Hobeln, Fräsen oder Schleifen in die Oberflächenseiten der Polymerfolien eingebracht werden. Die Ausnehmungen 4a, 4b können erfindungsgemäß in gleicher oder ungleichen Formen, Größen und Verteilungen erzeugt werden. In der gezeigten Ausführungsform sind die Abdeckung 2 und das Polymerfolienelement 1 hinsichtlich ihrer zueinander gerichteten Oberflächenseiten mit den Ausnehmungen 4a und 4b deckungsgleich ausgestaltet, so dass die übereinander angeordneten Ausnehmungen 4a und 4b im entstehenden Polymerfolienverbund 3 jeweils einen gemeinsamen Hohlraum 5 ausbilden können. Vorteilhafterweise kann die Höhe der Hohlräume 5 in diesem Fall bei gleichen Polymerfoliendicken deutlich größer sein als bei Verwendung einer durchgehenden Abdeckung ohne Ausnehmungen. Durch die Wahl einer Abdeckung 2, die ebenfalls Ausnehmungen 4b aufweist, dann die Höhe der entstehenden Hohlräume vorteilhafterweise über einen sehr viel größeren Bereich ausgewählt und gegebenenfalls auf spezielle Anwendungen angepasst werden.

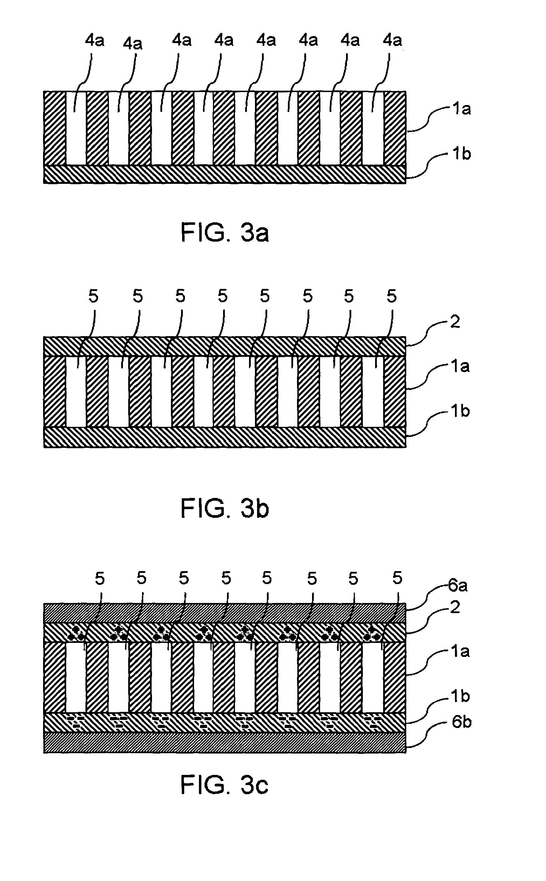

Die Figur 3a zeigt eine Schnittansicht eines Polymerfolienelements 1, welches aus einem Verbund von zwei Polymerfolien 1a und 1b gebildet werden kann. Die Verbindung der beiden Polymerfolien 1a und 1b kann beispielsweise durch Laminieren oder Kleben erfolgen. In die Polymerfolie 1a können dann erfindungsgemäß Ausnehmungen 4a mittels Abtrageverfahren, wie Laserablation, Ätzen, Fräsen, Hobeln oder Schleifen eingebracht werden. Im gezeigten Polymerfolienelement 1 sind die Ausnehmungen 4a in die Polymerfolie 1a durchgängig bis zur zweiten Polymerfolie 1b eingebracht. Durch die Abtragung des Polymermaterials bis zur Grenzfläche der Polymerfolien 1a und 1b kann vorteilhafterweise die Hohlraumhöhe genauer eingestellt und dadurch noch gleichförmigere Hohlräume erzeugt werden.

Die Figur 3b zeigt eine Schnittdarstellung eines erfindungsgemäßen Dreischichtverbunds 3 aus dem in Figur 3a gezeigten Polymerfolienelement 1 und einer durchgehenden Abdeckung 2. Die Ausnehmungen 4a werden durch die Abdeckung 2 unter Ausbildung einer Lage von Hohlräumen 5 verschlossen. Als eine Lage von Hohlräumen werden erfindungsgemäß solche verstanden und bezeichnet, in der gleichen Polymerfolienschicht ausgebildet sein können. Die Hohlräume innerhalb des gebildeten Polymerfolienverbunds können den herzustellenden Ferroelektret-Mehrschichtverbund vorteilhafterweise entlang seiner Dicke, also senkrecht zum Schichtverlauf der Polymerfolien 1a, 1b, 2 weicher machen, damit dessen Elastizitätsmodul erniedrigen, und einen Polungsprozess in den resultierenden Hohlräumen 5 ermöglichen.

Die Figur 3c ist eine schematische Schnittansicht durch die in Fig. 3b gezeigte Anordnung nach dem Aufladungsprozess und nach dem Anbringen von Elektroden 6a und 6b. Das Aufladen kann beispielsweise durch Triboaufladung, Elektronenstrahlbeschuss, Anlegen einer elektrischen Spannung an die Elektroden oder Coronaentladung erfolgen. Insbesondere kann das Aufladen durch eine Zweielektroden-Corona-Anordnung erfolgen. Dabei kann die Nadelspannung mindestens ≥20 kV, beispielsweise mindestens ≥25 kV, insbesondere mindestens ≥30 kV, betragen. Die Aufladezeit kann dabei mindestens > 0 s, beispielsweise mindestens ≥30 s, insbesondere mindestens ≥1 min, betragen. Die durchgehende Polymerfolie 1b und die Abdeckung 2 kontaktieren jeweils eine Elektrode 6a, 6b. Die Elektroden 6a, 6b sind dabei als Elektrodenschichten jeweils auf den Seiten der Polymerfolie 1b und der Abdeckung 2 ausgebildet, welche gegenüberliegend zu den Seiten, an denen die Hohlräume 5 ausbildende, Ausnehmungen umfassende Polymerschicht 1a angrenzt, angeordnet sind.

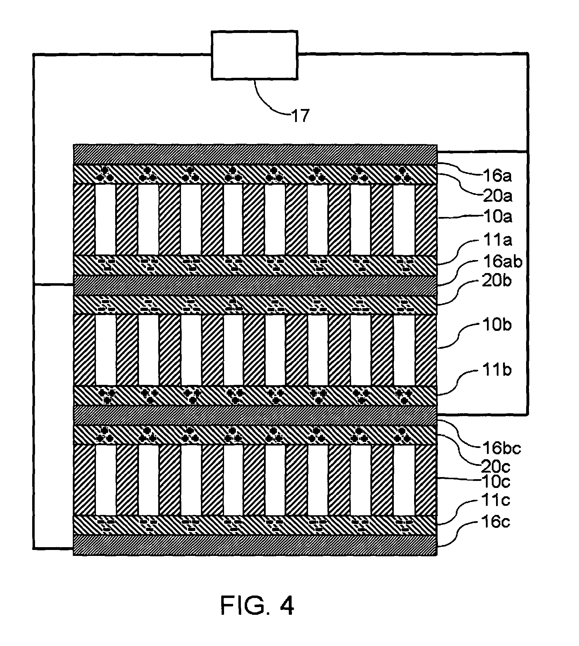

Figur 4 zeigt einen schematischen Querschnitt durch einen erfindungsgemäßen elektromechanischen Wandler mit drei aufeinander gestapelten erfindungsgemäßen Ferroelektret Mehrschicht-Anordnungen, wie sie in Figur 3c dargestellt ist, welche jeweils eine durchgehende Polymerfolie 11a, 11b, 11c, eine Ausnehmungen umfassende Polymerschicht 10a, 10b, 10c, die jeweils gemeinsam das Polymerfolienelement 1 bilden, und eine Abdeckung in Form einer dritten durchgehenden Polymerfolie 20a, 20b, 20c, umfassen. Figur 4 veranschaulicht, dass zwei benachbarte durchgehende Polymerfolien 11a, 20b; 11b, 20c der unterschiedlichen Anordnungen mit einer gleichen Polarisation aufgeladen sind und dabei die gleiche Elektrode 16ab; 16bc kontaktieren können. Figur 4 zeigt darüber hinaus eine Möglichkeit des Anschlusses der Elektroden 16a, 16ab, 16bc, 16c an eine Spannungs/Strom-Mess/Versorgungs/SpeicherVorrichtung 17.

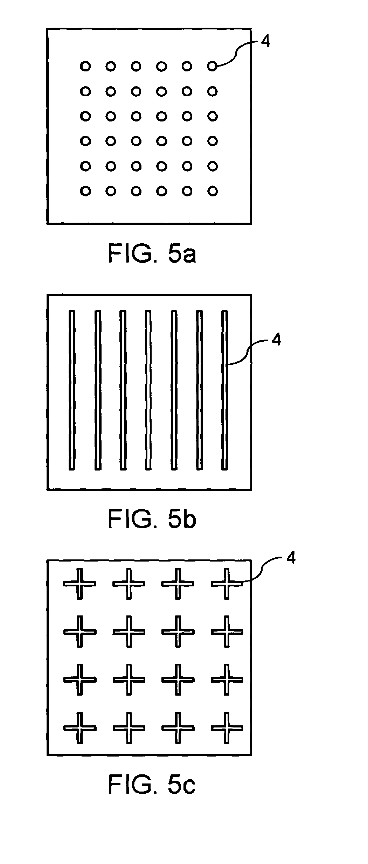

Die Fig. 5a-5e zeigen schematische Draufsichten auf verschiedene Ausführungsformen von Ausnehmungen 4 in Polymerfolienelementen 1 und/oder Abdeckungen 2 und damit die mögliche Ausgestaltung der Grundflächen der entsprechenden Hohlräume 5 quer zum Schichtverlauf der Polymerfolien 1 und/oder 2. Die gezeigten Strukturen können durch Abtrageverfahren, beispielsweise durch Laserablation, Fräsen, Hobeln oder Schleifen und/oder chemisch durch Ätzen, erzeugt werden. Grundsätzlich ist es möglich, die Abtragung so durchzuführen, dass die Formen als Positiv- oder Negativformen, also als Vertiefungen oder Erhebungen in den Polymerfolien 1 und 2 entstehen können. Die gezeigten Ausführungsformen und Ausgestaltungen der Ausnehmungen 4 stellen nur Beispiele dar und sollen die Erfindung nicht in irgendeiner Form einschränken. Aus Gründen der Übersichtlichkeit ist in den Figuren 5a bis 5e jeweils nur eine Ausnehmung einer Form beispielhaft mit einem Bezugszeichen gekennzeichnet.

Figur 5a zeigt eine Draufsicht auf eine Ausnehmungen 4 umfassende Polymerfolie 1, wobei die Ausnehmungen 4 eine kreisförmige Grundfläche aufweisen. Die Ausnehmungen 4 können, wie in Figur 5a veranschaulicht, darüber hinaus als eine Vielzahl von Ausnehmungen 4 ausgebildet werden.

Figur 5b zeigt eine Draufsicht auf eine Ausnehmungen 4 umfassende Polymerfolie 1, wobei die Ausnehmungen 4 eine längliche, rechteckige Grundfläche aufweisen.

Figur 5c zeigt eine Draufsicht auf eine Ausnehmungen 4 umfassende Polymerfolie 1, deren Ausnehmungen 4 eine kreuzförmige Grundfläche aufweisen.

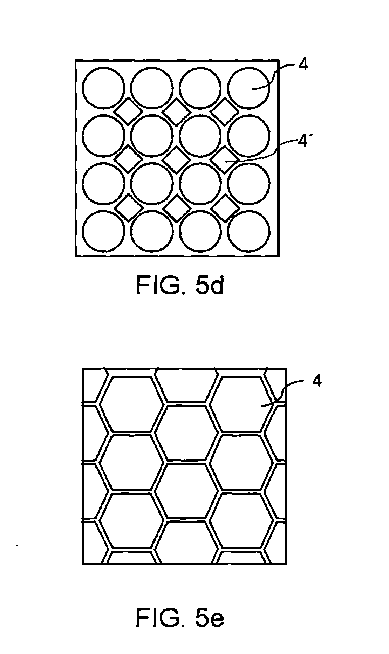

Figur 5d zeigt eine, verschiedene Ausnehmungen 4, 4' umfassende strukturierte Polymerfolie, deren Ausnehmungen teilweise eine kreisförmige Grundfläche 4 und teilweise eine rautenförmige Grundfläche 4' aufweisen. Figur 5d veranschaulicht, dass bei einer homogen verteilten Anordnung von Ausnehmungen mit kreisförmigen 4 und rautenförmigen 4' Querschnittsflächen vorteilhaft ein besonders großes Gesamthohlraumvolumen erzielt werden kann.

Figur 5e zeigt eine Ausnehmungen 4 umfassende Polymerfolie 1, deren Vertiefungen 4 eine wabenförmige Grundfläche aufweisen. Figur 5e veranschaulicht, dass durch eine Anordnung, welche ausschließlich auf Ausnehmungen 4 mit wabenförmigen Querschnittsflächen basiert, ebenfalls ein vorteilhaft großes Gesamthohlraumvolumen erzielt werden kann.

## Patentansprüche

1. Verfahren zur Herstellung eines Ferroelektret- Zwei- oder Mehrschichtverbunds (3) mit Hohlräumen (5) **gekennzeichnet durch** die folgenden Schritte:
A) Einbringen von einer oder mehreren Ausnehmungen (4a) in mindestens eine Oberflächeseite eines Polymerfolienelements (1) mittels Abtrageverfahren,
B) Aufbringen einer ersten Abdeckung (2) auf die in Schritt A) gebildete, Ausnehmungen (4) umfassende Oberflächenseite des Polymerfolienelements (1), und
C) Verbinden des Polymerfolienelements (1) und der Abdeckung (2), zu einem Polymerfolienverbund (3) wobei die Ausnehmungen (4) unter Ausbildung von Hohlräumen (5) verschlossen werden.

2. Verfahren nach Anspruch 1 **dadurch gekennzeichnet, dass** Einbringen der Ausnehmungen (4a) in Schritt A) durch Laserablation, durch Ätzen, durch Hobeln, durch Schleifen und/oder durch Fräsen erfolgt.

3. Verfahren nach Anspruch 1 **dadurch gekennzeichnet, dass** in eine Oberflächenseite der Abdeckung (2) in einem Schritt A1) eine oder mehrere Ausnehmungen (4b) eingebracht werden.

4. Verfahren nach Anspruch 3 **dadurch gekennzeichnet, dass** die Ausnehmungen (4b) in der Oberflächenseite der Abdeckung (2) sowie die Ausnehmungen (4a) in der Oberflächenseite des Polymerfolienelements (1) mindestens teilweise überlappend angeordnet sind und somit einen gemeinsamen Hohlraum (5) bilden.

5. Verfahren nach Anspruch 1 **dadurch gekennzeichnet, dass** das Polymerfolienelement (1) und/oder die Abdeckung (2) mindestens eine erste und eine zweite miteinander verbundene Polymerfolie (1a, 1b); (2a, 2b) umfassen.

6. Verfahren nach Anspruch 5 **dadurch gekennzeichnet, dass** in Schritt A) die Einbringung der Ausnehmungen (4a) in die Oberflächenseite des Polymerfolienelements (1, 1a) und/oder in Schritt A1) die Einbringung der Ausnehmungen (4b) in die Oberflächenseite der Abdeckung (2) durchgängig bis zur zweiten Polymerfolie (1b, 2b) erfolgt.

7. Verfahren nach Anspruch 1 **dadurch gekennzeichnet, dass** das Verbinden des Polymerfolienelements (1) und der Abdeckung (2) zu einem Polymerfolienverbund (3) in Schritt C) durch Laminieren, Kleben, Klammern, Klemmen, Schrauben, Nieten oder Schweißen erfolgt.

8. Verfahren nach Anspruch 1 **dadurch gekennzeichnet, dass** vor und/oder nach einer elektrischen Aufladung der inneren Oberflächen der Hohlräume (5) in einem Schritt D) die Aufbringung von Elektroden (6) an den nach außen gerichteten Oberflächen des Polymerfolienverbunds (3) erfolgt.

9. Verfahren nach Anspruch 1 **dadurch gekennzeichnet, dass** die Schritte A), B), C) und/oder D) als kontinuierlicher Rolle-zu-Rolle Prozess durchgeführt werden.

10. Verfahren nach Anspruch 1 **dadurch gekennzeichnet, dass** es als weiteren Schritt E) vor oder nach elektrischer Aufladung der inneren Oberflächen der Hohlräume (5) in Schritt D) das Versiegeln der Kanten des in Schritt c) gebildeten Polymerfolienverbunds (3) umfasst.

11. Verfahren nach Anspruch 1 **dadurch gekennzeichnet, dass** in einem weiteren Schritt F) vor der Polung in Schritt D) das Einfüllen eines Gases in die Hohlräume (5) im Polymerfolienverbund (3) umfasst.

12. Ferroelektret-Zwei- oder Mehrschichtverbund umfassend
- mindestens ein erstes Polymerfolienelement (1) mit mindestens einer Ausnehmungen (4a) umfassenden Oberflächenseite, und
- mindestens eine erste Abdeckung (2),
wobei die Abdeckung (2) auf der ersten Ausnehmungen (4a) umfassenden Oberflächenseite Polymerfolienelements (1) angeordnet ist, und
wobei die Ausnehmungen (4a) durch die Abdeckung (2) unter Ausbildung von Hohlräumen (5) verschlossen sind.

13. Ferroelektret-Zwei- oder Mehrschichtverbund **dadurch gekennzeichnet, dass** dieser nach einem Verfahren gemäß Anspruch 1 hergestellt wurde.

14. Piezoelektrisches Element enthaltend einen Ferroelektret Zwei- oder Mehrschichtverbund nach Anspruch 12 oder 13 **dadurch gekennzeichnet, dass** das Polymerfolienelement und/oder die Abdeckung mindestens zwei miteinander verbundene Polymerfolien umfassen.

15. Piezoelektrisches Element nach Anspruch 14 **dadurch gekennzeichnet, dass** es ein Sensor-Aktor- und/oder Generatorelement ist.
